# EUROPÄISCHE PATENTSCHRIFT

(11) **EP 1 097 766 B1**
(45) Veröffentlichungstag und Bekanntmachung des Hinweises auf die Patenterteilung: **14.07.2004**
(21) Anmeldenummer: 00120058.3
(22) Anmeldetag: 15.09.2000
(51) Int. Cl.: B22D 13/02, C23C 14/34

(54) **Rohrtarget**
Tubular sputtering target
Cible de pulvérisation tubulaire

(30) Priorität: 05.11.1999 DE 19953470
(43) Veröffentlichungstag der Anmeldung: 09.05.2001
(73) Patentinhaber: W.C. Heraeus GmbH & Co. KG, 63450 Hanau (DE)
(72) Erfinder: Bach, Otto, 61137 Schöneck (DE); Bohmeier, Hans, Dr., 09599 Freiberg (DE); Heck, Ralf, 63454 Hanau (DE); Lupton, David, Dr., 63571 Gelnhausen (DE)
(74) Vertreter: Kühn, Hans-Christian

(56) Entgegenhaltungen:
- EP-A- 0 500 031
- US-A- 4 240 494
- PATENT ABSTRACTS OF JAPAN vol. 004, no. 092 (M-018), 3. Juli 1980 (1980-07-03) & JP 55 050958 A (KUBOTA LTD), 14. April 1980 (1980-04-14)
- PATENT ABSTRACTS OF JAPAN vol. 015, no. 289 (C-0852), 23. Juli 1991 (1991-07-23) & JP 03 104840 A (AISIN SEIKI CO LTD;OTHERS: 01), 1. Mai 1991 (1991-05-01)
- PATENT ABSTRACTS OF JAPAN vol. 015, no. 385 (C-0871), 27. September 1991 (1991-09-27) & JP 03 153867 A (TOSOH CORP), 1. Juli 1991 (1991-07-01)
- PATENT ABSTRACTS OF JAPAN vol. 015, no. 385 (C-0871), 27. September 1991 (1991-09-27) & JP 03 153868 A (TOSOH CORP), 1. Juli 1991 (1991-07-01)

## Beschreibung

Die Erfindung betrifft ein Rohrtarget für Kathodenzerstäubungsanlagen, ein Verfahren zur Herstellung eines zylindrischen Hohlkörpers für ein solches Rohrtarget und seine Verwendung.

Rotierende Rohrtargets für Kathodenzerstäubungsanlagen sind bekannt. Sie werden überwiegend für die Herstellung großflächiger Beschichtungen, beispielsweise für die Beschichtung von Flachglas, verwendet. Rohrtargets ermöglichen im Vergleich zu planaren Targets eine höhere Ausbeute an Targetmaterial, was insbesondere bei hochwertigen Beschichtungsmaterialien wie Edelmetallen von größter wirtschaftlicher Bedeutung ist.

Für die Herstellung eines Target-Rohres beziehungsweise eines zylindrischen Hohlkörpers aus Beschichtungsmaterial sind unterschiedliche Verfahren bekannt. Um mit dem Rohrtarget hohe Zerstäubungsleistungen und eine hohe Gleichmäßigkeit beziehungsweise eine einheitliche Dikke der erzeugten Beschichtung zu erzielen, wird eine gleichmäßige, feine Komstruktur des Targetmaterials angestrebt.
So kann ein Target-Rohr aus Metall durch Gießen eines massiven Barrens, Schmieden des Barrens zu einem zylindrischen Knüppel und anschließende Herstellung eines Rohres durch spanende Bearbeitung hergestellt werden. Die Materialausbeute bei diesem Verfahren ist allerdings gering und die Zerspanung aufwendig. Zudem sind hohe Umformgrade erforderlich, um eine gleichmäßige, feine Kornstruktur zu erzielen.
Die Herstellung eines metallischen Target-Rohres kann aber auch durch Strangguss mit anschließender spanender Bearbeitung der Innen- und Außendurchmesser erfolgen. Aufgrund der langsamen Erstarrung des Rohres beim Strangguss entsteht allerdings ein grobkörniges und damit weniger geeignetes Gefüge. Beim Horizontal-Strangguss bildet sich zudem über den Rohrquerschnitt eine ungleichmäßige Kornstruktur, die zu unterschiedlichen Abscheideraten führt.
Ein metallisches Target-Rohr kann auch durch Umformen eines dicken Bandes zu einer rohrförmigen Geometrie und Schließen der Längsnaht durch Schweißen hergestellt werden. Die Schweißnaht weist allerdings ein ungleichmäßiges Gefüge auf, das sich vom Material des umgeformten Bandes unterscheidet.
Eine Herstellung mittels Strangpressen eines hohlzylindrischen Bolzens ist sowohl für metallische als auch für keramische Beschichtungsmaterialien möglich. Die Materialausbeute ist jedoch gering.
US 5,354,446 beschreibt ein drehbares Rohrtarget nach dem Magnetron-Prinzip mit keramischem Beschichtungsmaterial zur Kathodenzerstäubung. Das Target weist einen Target-Träger auf, der zwei metallische Schichten und als oberste Schicht eine keramische Schicht aufweist. Die Wärmeausdehnungskoeffizienten der beiden metallischen Schichten sind so gewählt, dass ein quasi fließender Übergang zwischen dem Wärmeausdehnungskoeffizienten des Target-Trägers und dem der keramischen Schicht erzeugt wird. Die Herstellung der Schichten erfolgt bevorzugt durch aufwendige Verfahren wie Plasmaspritzen oder Aufpressen von Schichtpartikeln mittels isostatischem Pressen oder heißisostatischem Pressen auf den Target-Träger.
FR 2 745 010 beschreibt ein Rohrtarget für die Kathodenzerstäubung, das aus mehreren langgestreckten Platten zusammengesetzt wird. Die äußere Rohrform ergibt dabei vorzugsweise ein Polygon. Langgestreckte Platten aus Standard-Materialien können in Form von Blechen oder Barren verwendet werden. Die Herstellung von langgestreckten Platten aus Sonder-Materialien kann durch Pressen, insbesondere durch isostatisches oder heißisostatisches Pressen erfolgen. Die Montage der Platten zu einem Rohr erfolgt durch Verschrauben, Löten oder Kleben.

Es stellt sich somit das Problem, ein einfaches und kostengünstiges Verfahren zur Herstellung eines zylindrischen Hohlkörpers für ein Rohrtarget sowie einen zylindrischen Hohlkörper mit gleichmäßigem, feinem Korngefüge bereitzustellen.

Das Problem wird für das Verfahren dadurch gelöst, dass der zylindrische Hohlkörper durch Schleudergießen einer Schmelze mit den Kennzeichnenden des Anspruchs 1 hergestellt wird. Unter einem zylindrischen Hohlkörper wird dabei ein rohrförmiger Rohling verstanden, der durch spanende Bearbeitung zu einem Target-Rohr verarbeitet und schließlich mit weiteren Teilen zu einem Rohrtarget zusammengebaut wird.
Bei dem Schleudergieß-Verfahren wird das Material für den zylindrischen Hohlkörper in eine bereits "endformnahe" Geometrie gegossen, wodurch nachfolgend nur eine geringe spanende Bearbeitung der Innen- und Außenkonturen des entstehenden zylindrischen Hohlkörpers erforderlich ist. Dies hat den Vorteil einer hohen Materialausbeute. Es hat sich gezeigt, dass durch den Schleuderguss in der Wandung des zylindrischen Hohlkörpers eine sehr gleichmäßige Kornstruktur mit im wesentlichen senkrecht zum Umfang des Hohlkörpers angeordneten, stengeligen Kristalliten ausgebildet wird. Diese Ausbildung des Komgefüges bewirkt, dass die Kristallite in einer Kathodenzerstäubungsanlage während eines Zerstäubungsvorganges immer senkrecht zu ihrem dünnen Querschnitt abgetragen werden. Somit ändert sich das Korngefüge und damit die Abscheiderate während der gesamten Einsatzzeit des Rohrtargets nicht. Aufgrund der beim Schleudergießen auftretenden Fliehkräfte werden Verunreinigungen im Gussmaterial wie zum Beispiel Schlacke, Kohle oder Graphit beziehungsweise auch Gasblasen beim Schleudern in Richtung des Innendurchmessers des entstehenden Hohlkörpers verdrängt und können in einfacher Weise bei der nachfolgenden spanenden Bearbeitung der Rohr-Innenkontur abgetragen werden. Dies führt zu einem sehr sauberen und homogenen Komgefüge des Target-Rohres und somit einer hohen Qualität des Rohrtargets. Zudem kann der Materialabfall, der durch die spanende Bearbeitung entsteht, im nächsten Guss größtenteils als Rücklauf wieder eingesetzt werden. Der Anteil an zugesetztem Rücklauf kann dabei generell zwischen 0% und 100% betragen.

Als besonders vorteilhaft hat es sich erwiesen, wenn der zylindrische Hohlkörper durch Horizontal-Schleudergießen in einer rotierenden Gießkokille hergestellt wird. Die Gasatmosphäre beim Schleuderguss sollte dem vergossenen Material so angepasst werden, dass dieses in seinen Eigenschaften möglichst wenig beeinflusst wird. Eine Gasatmosphäre in der Gießkokille mit einem niedrigen Sauerstoffpartialdruck ist dabei in den meisten Fällen von Vorteil. So können in einfacher Weise technische Gase wie Erdgas oder Argon oder Formiergas oder Stickstoff verwendet werden.

Der zylindrische Hohlkörper kann aus einem Metall und/oder einem Edelmetall gebildet werden. Dabei ist sowohl ein einschichtiger Aufbau des zylindrischen Hohlkörpers aus einem einzigen Material als auch ein mehrschichtiger Aufbau aus unterschiedlichen Materialien möglich. Um einen qualitativ hochwertigen, mehrschichtigen zylindrischen Hohlkörper durch Schleuderguss herzustellen, wird beispielsweise ein zylindrischer Hohlkörper aus einem Edelmetall hergestellt und abgekühlt. Bevor der Innendurchmesser dieses Hohlkörpers mit einer weiteren Schicht versehen wird, sollte die Innenkontur mittels eines Bearbeitungsschrittes gesäubert und geglättet werden. In den so bearbeiteten zylindrischen Hohlkörper kann nun eine andere Schmelze aus Metall durch Schleudergießen eingebracht werden, die den Innendurchmesser des zylindrischen Hohlkörpers belegt. Bei Materialien mit stark unterschiedlichen thermischen Ausdehnungskoeffizienten kann eine Spannungen ausgleichende Zwischenschicht vorgesehen werden.
Insbesondere die Herstellung eines zylindrischen Hohlkörpers aus Silber ist wirtschaftlich interessant. Auch AgCuNi-Legierungen, die in der Handhabung aufgrund ihrer höheren Festigkeit im Vergleich zu reinem Silber günstiger sind, sowie Ag-Werkstoffe mit geringen Dotierungen, wie zum Beispiel ein Feinkornsilber mit 0,15 Gew.-% Nickel, können verwendet werden. Besonders vorteilhaft ist, dass zylindrische Hohlkörper aus Legierungen hergestellt werden können, die aufgrund ihrer ungünstigen Verformungseigenschaften mit anderen Verfahren nicht herstellbar sind.

Das Problem wird für das Rohrtarget dadurch gelöst, dass das Rohrtarget einen schleudergegossenen, zylindrischen Hohlkörper mit den kennzeichnenden Merkmalen des Anspruchs 7 aufweist. Mit einem solchen Rohrtarget sind über große Flächen gleichmäßig dicke Schichten bei einer hohen Abscheiderate erzielbar.

Eine Verwendung von schleudergegossenen, zylindrischen Hohlkörpern für Rohrtargets ist von großem Vorteil. Insbesondere eine Verwendung von Rohrtargets mit schleudergegossenen, zylindrischen Hohlkörpem aus Silber für die Beschichtung von Flachglas hat sich bewährt.

Nachfolgende drei Beispiele dienen zur beispielhaften Erläuterung der Erfindung.
Bsp. 1: Herstellung eines zylindrischen Hohlkörpers mit einer Länge von 1000mm
Bsp. 2: Herstellung eines zylindrischen Hohlkörpers mit einer Länge von 4000mm
Bsp. 3: Spanende Bearbeitung des zylindrischen Hohlkörpers

### Beispiel 1:

Ein Material aus 70 Gew.-% Silber-Granalien und 30 Gew.-% Silber aus Rücklauf wird in einem Tongraphit-Tiegel eingeschmolzen, wobei die Silber-Schmelze mit Holzkohle oder Graphit abgedeckt wird. Die Silber-Schmelze wird bei einer Temperatur von 1100°C in eine Gießpfanne abgegossen, in der sich ein vorgewärmter Tongraphit-Tiegel befindet. Aus der Gießpfanne wird die Silber-Schmelze ohne Unterbrechung in die auf 100°C vorgewärmte, rotierende Gießkokille einer Horizontal-Schleudergussanlage gegossen, deren Drehzahl so eingestellt wird, dass die auf die einzubringende Schmelze wirkende Beschleunigung dem 160- bis 180-fachen der Erdbeschleunigung entspricht.

Der Außendurchmesser des zylindrischen Hohlkörpers wird durch den Innendurchmesser der Gießkokille bestimmt, während die Dicke der Wandung des Hohlkörpers über die Menge an eingebrachter Schmelze eingestellt wird. Um eine Sauerstoffaufnahme der Silber-Schmelze weitgehend zu vermeiden, wird die Kokille während des Gusses mit Erdgas gespült. Die Silber-Schmelze erstarrt rohrförmig an der Wandung der Gießkokille. Der entstandene zylindrische Hohlkörper kann nach dem Abkühlen aus der Gießkokille entnommen und spanend bearbeitet werden.

### Beispiel 2:

Die Herstellung des zylindrischen Hohlkörpers erfolgt im wesentlichen wie in Beispiel 1. Aufgrund der großen Länge von 4000mm wird die Temperatur der Schmelze jedoch bei 1250°C gewählt und die Gießkokille auf 200°C vorgeheizt.

### Beispiel 3:

Der Gießkokille entnommene zylindrische Hohlkörper wird mit einer konventionellen Bandsäge abgelängt und der Innendurchmesser mit einer Tiefbohrmaschine bearbeitet. Mit Einsatz des Tiefbohrverfahrens wird eine hohe Zerspanungsleistung, enge Bohrungstoleranzen, hohe Fluchtgenauigkeit, exakte Geometrie und hohe Oberflächenqualität erzeugt. Die Bearbeitung des Außendurchmessers erfolgt auf einer Langbettdrehmaschine. Zur Vermeidung von Durchbiegung bei den langen zylindrischen Hohlkörpern wird die jeweils bearbeitete Drehfläche durch einen mitlaufenden Setzstock (Lünette) und/oder feststehende Setzstöcke abgestützt.

## Patentansprüche

1. Verfahren zur Herstellung eines zylindrischen Hohlkörpers für ein Rohrtarget für Kathodenzerstäubungsanlagen, wobei der zylindrische Hohlkörper durch Schleudergießen einer Schmelze hergestellt wird, **dadurch gekennzeichnet, dass** eine Drehzahl der Gießkokille so eingestellt wird, dass eine auf die einzubringende Schmelze wirkende Beschleunigung dem 160- bis 180-fachen der Erdbeschleunigung entspricht.

2. Verfahren nach Anspruch 1, **dadurch gekennzeichnet, dass** der zylindrische Hohlkörper durch Horizontal-Schleudergießen in einer rotierenden Gießkokille hergestellt wird.

3. Verfahren nach mindestens einem der Ansprüche 1 bis 2, **dadurch gekennzeichnet, dass** das Schleudergießen in einer Gasatmosphäre mit einem niedrigen Sauerstoffpartialdruck erfolgt.

4. Verfahren nach Anspruch 3, **dadurch gekennzeichnet, dass** die Gasatmosphäre in der Gießkokille aus Erdgas oder Argon oder Formiergas oder Stickstoff gebildet wird.

5. Verfahren nach mindestens einem der Ansprüche 1 bis 4, **dadurch gekennzeichnet, dass** der zylindrische Hohlkörper aus einem Metall und/oder einem Edelmetall gebildet wird.

6. Verfahren nach Anspruch 5, **dadurch gekennzeichnet, dass** der zylindrische Hohlkörper aus Silber gebildet wird.

7. Rohrtarget für Kathodenzerstäubungsanlagen, wobei das Rohrtarget einen schleudergegossenen, zylindrischen Hohlkörper aufweist, und der Hohlkörper eine Komstruktur mit im wesentlichen senkrecht zum Umfang des Hohlkörpers angeordneten, stengeligen Kristalliten aufweist, und aus Silber gebildet ist.

8. Verwendung von schleudergegossenen, zylindrischen Hohlkörpern zur Herstellung von Rohrtargets für Kathodenzerstäubungsanlagen.

9. Verwendung von Rohrtargets, die schleudergegossene, zylindrische Hohlkörper aus Silber aufweist für die Beschichtung von Flachglas in Kathodenzerstäubungsanlagen.

## Claims

1. A method for the manufacture of a cylindrical hollow body for a tube target for cathode sputtering plants with the cylindrical hollow body being manufactured by spin casting of a melt, **characterized in that** a speed of the mold block is adjusted such that an acceleration acting upon the melt to be introduced will be equivalent to 160 to 180 times the acceleration due to gravity.

2. A method according to Claim 1, **characterized in that** the cylindrical hollow body is manufactured by horizontal spin casting in a rotating mold block.

3. A method according to at least one of the Claims 1 to 2, **characterized in that** spin casting takes place in a gas atmosphere with low partial oxygen pressure.

4. A method according to Claim 3, **characterized in that** the gas atmosphere in the mold block is formed by natural gas or argon or forming gas or nitrogen.

5. A method according to at least one of the Claims 1 to 4, **characterized in that** the cylindrical hollow body is formed of a metal and/or a precious metal.

6. A method according to Claim 5, **characterized in that** the cylindrical hollow body is made of silver.

7. A tube target for cathode sputtering plants with the tube target having a spin-cast cylindrical hollow body, and the hollow body having a grain structure with columnar crystallites essentially perpendicular to the circumference of the hollow body and being made of silver.

8. The use of spin-cast cylindrical hollow bodies to manufacture tube targets for cathode sputtering plants.

9. The use of tube targets having spin-cast cylindrical hollow bodies of silver for coating flat glass in cathode sputtering plants.

## Revendications

1. Procédé de fabrication d'un corps creux cylindrique pour une cible de pulvérisation tubulaire pour des installations de pulvérisation cathodique, le corps creux cylindrique étant fabriqué par coulage par centrifugation d'une fonte, **caractérisé en ce qu'**une vitesse de rotation de la lingotière de coulée est réglée de manière telle qu'une accélération agissant sur la fonte à introduire correspond à un multiple de l'accélération de la pesanteur compris entre 160 et 180 fois celle-ci.

2. Procédé selon la revendication 1, **caractérisé en ce que** le corps creux cylindrique est fabriqué par coulage par centrifugation horizontale dans une lingotière de coulée rotative.

3. Procédé selon au moins l'une des revendications 1 à 2, **caractérisé en ce que** le coulage par centrifugation se fait sous une atmosphère gazeuse à faible pression partielle d'oxygène.

4. Procédé selon la revendication 3, **caractérisé en ce que** l'atmosphère gazeuse est formée dans la lingotière de coulée au départ de gaz naturel ou d'argon ou de forming gaz ou d'azote.

5. Procédé selon au moins l'une des revendications 1 à 4, **caractérisé en ce que** le corps creux cylindrique est constitué d'un métal et/ou d'un métal noble.

6. Procédé selon la revendication 5, **caractérisé en ce que** le corps creux cylindrique est constitué d'argent.

7. Cible de pulvérisation tubulaire pour installations de pulvérisation cathodique, la cible de pulvérisation tubulaire comportant un corps creux cylindrique coulé par centrifugation et le corps creux présentant une structure granulaire avec des cristallites colonnaires agencées de manière sensiblement verticale par rapport au pourtour du corps creux, et étant constitué d'argent.

8. Utilisation de corps creux cylindriques coulés par centrifugation pour la fabrication de cibles de pulvérisation tubulaires pour installations de pulvérisation cathodique.

9. Utilisation de cibles de pulvérisation tubulaires comportant des corps creux cylindriques en argent, coulés par centrifugation, pour le revêtement de verre plat dans des installations de pulvérisation cathodique.
